# EUROPEAN PATENT APPLICATION

(11) **EP 4 565 010 A1**
(43) Date of publication of application: **04.06.2025**
(21) Application number: 23846411.9
(22) Date of filing: 21.07.2023
(51) Int. Cl.: H05H 1/46

(54) **PLASMA PROCESSING DEVICE, AND METHOD FOR CONTROLLING SOURCE FREQUENCY OF SOURCE HIGH-FREQUENCY ELECTRIC POWER**

(30) Priority: 27.07.2022 JP 2022119840
(71) Applicant: Tokyo Electron Limited, Tokyo 107-6325 (JP)
(72) Inventor: YAZAKI, Yuma, Sapporo City, Hokkaido 060-0003 (JP); NAGAMI, Koichi, Kurokawa-gun, Miyagi 981-3629 (JP); KIKUCHI, Yuto, Kurokawa-gun, Miyagi 981-3629 (JP)
(74) Representative: Hoffmann Eitle
(86) International application number: PCT/JP2023/026832
(87) International publication number: WO 2024/024681

(57) **Abstract**

A plasma processing apparatus includes a chamber, a substrate support, a radio frequency power supply and a bias power supply. The substrate support includes a bias electrode and provided inside the chamber. The radio frequency power supply is configured to generate source radio frequency power for plasma generation within the chamber. The bias power supply is configured to periodically supply an electric bias having a waveform cycle to the bias electrode. The radio frequency power supply is configured to set a source frequency of the source radio frequency power in each of a plurality of phase periods within the waveform cycle to a frequency obtained by adding a shift amount for minimizing a degree of reflection of the source radio frequency power and random noise to the source frequency in a same phase period within a preceding waveform cycle.

## Description

### TECHNICAL FIELD

Exemplary embodiments of the present disclosure relate to a plasma processing apparatus and a method of controlling a source frequency of source radio frequency power.

### BACKGROUND

A plasma processing apparatus is used for plasma processing on a substrate. In the plasma processing apparatus, bias radio frequency power is employed to draw ions into a substrate from plasma generated within a chamber. Patent Document 1 below discloses a plasma processing apparatus that modulates the power level and frequency of bias radio frequency power.

### [Prior Art Document]

[Patent Document]
Patent Document 1: Japanese laid-open publication No. 2009-246091

### SUMMARY

The present disclosure provide a technique for reducing a degree of reflection of source radio frequency power in a plasma processing apparatus.

According to one embodiment of the present disclosure, there is provided a plasma processing apparatus including: a chamber; a substrate support having a bias electrode and provided inside the chamber; a radio frequency power supply configured to generate source radio frequency power for plasma generation within the chamber; and a bias power supply configured to periodically supply an electric bias having a waveform cycle to the bias electrode, wherein the radio frequency power supply is configured to set a source frequency of the source radio frequency power in each of a plurality of phase periods within the waveform cycle to a frequency obtained by adding a shift amount for minimizing a degree of reflection of the source radio frequency power and random noise to the source frequency in a same phase period within a preceding waveform cycle.

According to one exemplary embodiment, a degree of reflection of source radio frequency power in a plasma processing apparatus is reduced.

### BRIEF DESCRIPTION OF DRAWINGS

FIG. 1 is a diagram illustrating a configuration example of a plasma processing system.
FIG. 2 is a diagram illustrating a configuration example of a capacitively coupled plasma processing apparatus.
FIG. 3 is a diagram illustrating a configuration example of a power supply system in the plasma processing apparatus according to one exemplary embodiment.
FIG. 4 is a diagram illustrating an example of the waveform of an electric bias.
FIG. 5 is a timing chart illustrating an example of the electric bias and the source frequency of source radio frequency power.
FIGS. 6A and 6B are timing charts illustrating an example of the source radio frequency power and electric bias, respectively.
FIGS. 7A and 7B are timing charts illustrating an example of the source radio frequency power and electric bias, respectively.
FIG. 8 is a timing chart illustrating an example of the electric bias and the source frequency of source radio frequency power.
FIGS. 9A and 9D are timing charts illustrating another example of an electric bias.
FIG. 10 is a flowchart illustrating a method of controlling the source frequency of source radio frequency power according to one exemplary embodiment.

### DETAILED DESCRIPTION

Hereinafter, various exemplary embodiments will be described in detail with reference to the drawings. In addition, the same reference numerals will be given to the same or corresponding parts in each drawing.

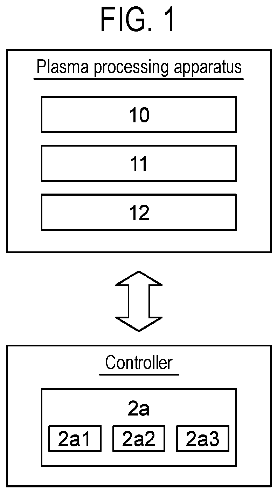

FIG. 1 is a diagram illustrating a configuration example of a plasma processing system. In one embodiment, the plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber 10, a substrate support 11, and a plasma generator 12. The plasma processing chamber 10 has a plasma processing space. Further, the plasma processing chamber 10 has at least one gas supply port for supplying at least one processing gas into the plasma processing space, and at least one gas discharge port for discharging the gas from the plasma processing space. The gas supply port is connected to a gas supplier 20 to be described later, and the gas discharge port is connected to an exhaust system 40 to be described later. The substrate support 11 is arranged in the plasma processing space and has a substrate support surface for supporting a substrate.

The plasma generator 12 is configured to generate plasma from the at least one processing gas supplied into the plasma processing space. The plasma generated in the plasma processing space may be a capacitively coupled plasma (CCP), inductively coupled plasma (ICP), electron-cyclotron-resonance (ECR) plasma, helicon wave excitation plasma (HWP), or surface wave plasma (SWP), among others.

The controller 2 processes computer-executable instructions that cause the plasma processing apparatus 1 to execute various steps described in the present disclosure. The controller 2 may be configured to control each component of the plasma processing apparatus 1 so as to execute various steps described herein. In one embodiment, a part or all of the controller 2 may be included in the plasma processing apparatus 1. The controller 2 may include a processor 2a1, a storage 2a2, and a communication interface 2a3. The controller 2 is realized, for example, by a computer 2a. The processor 2a1 may be configured to perform various control operations by reading a program from the storage 2a2 and executing the read program. The program may be stored in advance in the storage 2a2, or may be acquired via a medium when necessary. The acquired program is stored in the storage 2a2, and is read from the storage 2a2 to be executed by the processor 2a1. The medium may be any of various non-transitory storage media readable by the computer 2a, or may be a communication line connected to the communication interface 2a3. The processor 2a1 may be a programmable logic device processor, such as a central processing unit (CPU) or field-programmable gate array (FPGA). The storage 2a2 may include a random access memory (RAM), a read only memory (ROM), a hard disk drive (HDD), a solid state drive (SSD), or a combination thereof. The communication interface 2a3 may communicate with the plasma processing apparatus 1 via a communication line such as a local area network (LAN).

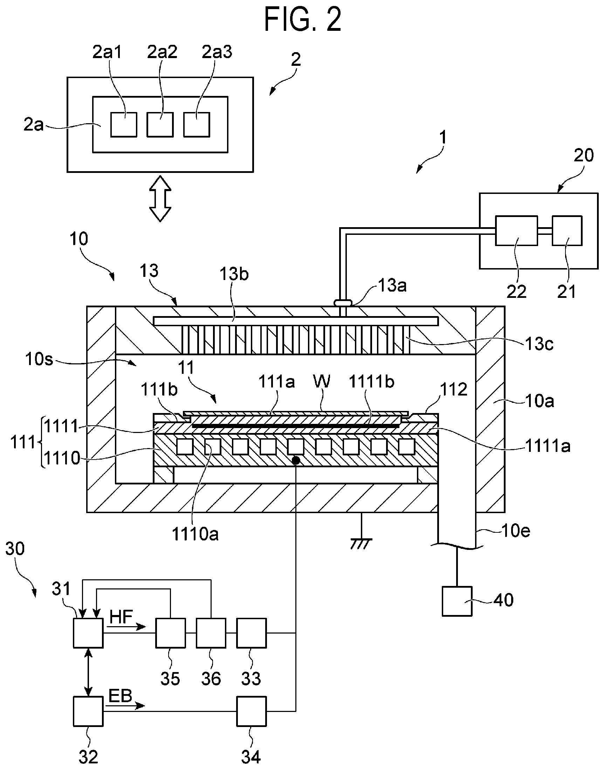

Hereinafter, a configuration example of a capacitively coupled plasma processing apparatus as an example of the plasma processing apparatus 1 will be described. FIG. 2 is a diagram illustrating a configuration example of a capacitively coupled plasma processing apparatus.

The capacitively coupled plasma processing apparatus 1 includes the plasma processing chamber 10, the gas supplier 20, a power supply system 30, and the exhaust system 40. Further, the plasma processing apparatus 1 includes the substrate support 11 and a gas introducer. The gas introducer is configured to introduce at least one processing gas into the plasma processing chamber 10. The gas introducer includes a shower head 13. The substrate support 11 is arranged inside the plasma processing chamber 10. The shower head 13 is located above the substrate support 11. In one embodiment, the shower head 13 constitutes at least a part of the ceiling of the plasma processing chamber 10. The plasma processing chamber 10 has a plasma processing space 10s defined by the shower head 13, a sidewall 10a of the plasma processing chamber 10, and the substrate support 11. The plasma processing chamber 10 is grounded. The substrate support 11 is electrically insulated from a housing of the plasma processing chamber 10.

The substrate support 11 includes a main body 111 and a ring assembly 112. The main body 111 has a central region 111a for supporting a substrate W and an annular region 111b for supporting the ring assembly 112. A wafer is an example of the substrate W. The annular region 111b of the main body 111 surrounds the central region 111a of the main body 111 in a plan view. The substrate W is disposed on the central region 111a of the main body 111, and the ring assembly 112 is disposed on the annular region 111b of the main body 111 to surround the substrate W on the central region 111a of the main body 111b. Thus, the central region 111a is also referred to as a substrate support surface for supporting the substrate W, and the annular region 111b is also referred to as a ring support surface for supporting the ring assembly 112.

In one embodiment, the main body 111 includes a base 1110 and an electrostatic chuck 1111. The base 1110 includes a conductive member. The electrostatic chuck 1111 is disposed on the base 1110. The electrostatic chuck 1111 includes a ceramic member 1111a and an electrostatic electrode 1111b embedded in the ceramic member 1111a. The ceramic member 1111a has the central region 111a. In one embodiment, the ceramic member 1111a also has the annular region 111b. In addition, another member surrounding the electrostatic chuck 1111, such as an annular electrostatic chuck or an annular insulating member, may have the annular region 111b. In this case, the ring assembly 112 may be disposed on the annular electrostatic chuck or the annular insulating member, or may be disposed on both the electrostatic chuck 1111 and the annular insulating member.

The ring assembly 112 includes one or multiple annular members. In one embodiment, one or multiple annular members include one or multiple edge rings and at least one covering. The edge ring is made of a conductive material or an insulating material, and the covering is made of an insulating material.

Further, the substrate support 11 may include a temperature regulation module configured to regulate at least one of the electrostatic chuck 1111, the ring assembly 112, and the substrate to a target temperature. The temperature regulation module may include a heater, a heat transfer medium, a flow path 1110a, or a combination thereof. A heat transfer fluid such as brine or gas flows through the flow path 1110a. In one embodiment, the flow path 1110a is formed in the base 1110, and one or multiple heaters is/are embedded in the ceramic member 1111a of the electrostatic chuck 1111. Further, the substrate support 11 may include a heat transfer gas supplier configured to supply a heat transfer gas to a gap between the back surface of the substrate W and the central region 111a.

The shower head 13 is configured to introduce at least one processing gas from the gas supplier 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. Further, the shower head 13 includes at least one upper electrode. In addition to the shower head 13, the gas introducer may further include one or multiple side gas injectors (SGI) provided in one or multiple openings formed in the sidewall 10a.

The gas supplier 20 may include at least one gas source 21 and at least one flow-rate controller 22. In one embodiment, the gas supplier 20 is configured to supply at least one processing gas from each corresponding gas source 21 to the shower head 13 through each corresponding flow-rate controller 22. Each flow-rate controller 22 may include, for example, a mass flow controller or a pressure-controlled flow-rate controller. Further, the gas supplier 20 may include at least one flow-rate modulation device that modulates or pulses the flow rate of at least one processing gas.

The exhaust system 40 may be connected to, for example, a gas discharge port 10e provided at the bottom of the plasma processing chamber 10. The exhaust system 40 may include a pressure adjustment valve and a vacuum pump. The internal pressure of the plasma processing space 10s is adjusted by the pressure adjustment valve. The vacuum pump may include a turbomolecular pump, a dry pump, or a combination thereof.

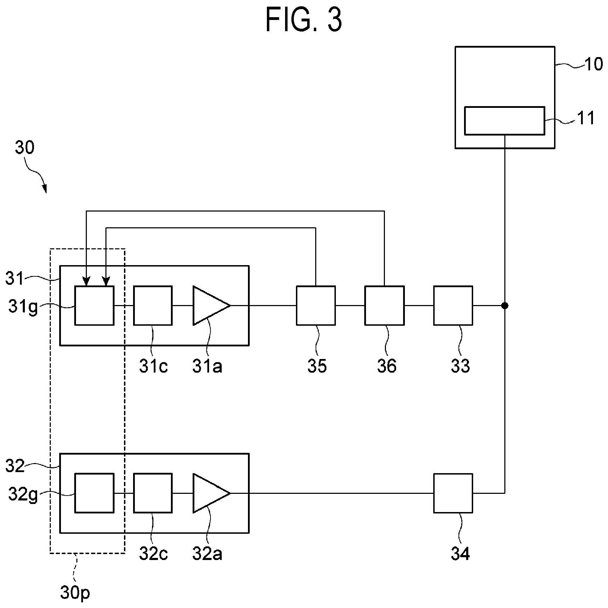

Hereinafter, reference will be made to FIG. 3 in combination with FIG. 2. FIG. 3 is a diagram illustrating a configuration example of a power supply system in the plasma processing apparatus according to one exemplary embodiment. The power supply system 30 includes a radio frequency power supply 31 and a bias power supply 32. The radio frequency power supply 31 constitutes the plasma generator 12 of one embodiment. The radio frequency power supply 31 is configured to generate source radio frequency power HF. The source radio frequency power HF has a source frequency f_{HF}. In other words, the source radio frequency power HF has a sinusoidal waveform with the source frequency f_{HF}. The source frequency f_{HF} may range from 10 MHz to 150 MHz.

The radio frequency power supply 31 is electrically connected to a radio frequency electrode via a matcher 33 and is configured to supply the source radio frequency power HF to the radio frequency electrode. The radio frequency electrode may be provided inside the substrate support 11. The radio frequency electrode may be at least one electrode provided inside the conductive member of the base 1110 or the ceramic member 1111a. Alternatively, the radio frequency electrode may be an upper electrode. When the source radio frequency power HF is supplied to the radio frequency electrode, plasma is generated from the gas within the chamber 10.

The matcher 33 has a variable impedance. The variable impedance of the matcher 33 is set to reduce reflection from the load of the source radio frequency power HF. The matcher 33 may be controlled, for example, by the controller 2.

In one embodiment, the radio frequency power supply 31 may include a signal generator 31g, a D/A converter 31c, and an amplifier 31a. The signal generator 31g generates a radio frequency signal with the source frequency f_{HF}. The signal generator 31g may be configured as a programmable logic device such as a programmable processor or a field-programmable gate array (FPGA). The signal generator 31g may be integrated into a single programmable device 30p together with a signal generator 32g to be described later, or may be configured as a separate programmable device from the signal generator 32g.

The output of the signal generator 31g is connected to the input of the D/A converter 31c. The D/A converter 31c converts the radio frequency signal from the signal generator 31g into an analog signal. The output of the D/A converter 31c is connected to the input of the amplifier 31a. The amplifier 31a amplifies the analog signal from the D/A converter 31c to generate the source radio frequency power HF. The amplification factor of the amplifier 31a is specified to the radio frequency power supply 31 by the controller 2. In addition, the radio frequency power supply 31 may not include the D/A converter 31c. In this case, the output of the signal generator 31g is connected to the input of the amplifier 31a, and the amplifier 31a amplifies the radio frequency signal from the signal generator 31g to generate the source radio frequency power HF.

The bias power supply 32 is electrically coupled to the substrate support 11. The bias power supply 32 is electrically connected to a bias electrode inside the substrate support 11 and is configured to supply an electric bias EB to the bias electrode. The bias electrode may be at least one electrode provided inside the conductive member of the base 1110 or the ceramic member 1111a. The bias electrode may be the radio frequency electrode. When the electric bias EB is supplied to the bias electrode, ions from the plasma are attracted to the substrate W.

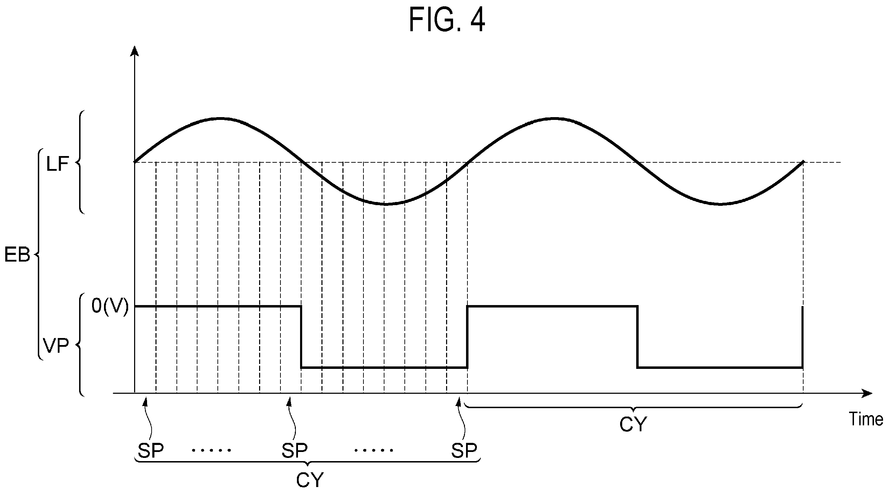

Hereinafter, reference will be made to FIGS. 3 and 4 in combination with FIG. 2. FIG. 4 is a diagram illustrating an example of the waveform of an electric bias. The bias power supply 32 is configured to periodically apply the electric bias EB with a waveform cycle CY to the bias electrode. In other words, the electric bias EB is applied to the bias electrode at each of multiple waveform cycles CY, which are repetitions of the waveform cycle CY. The waveform cycle CY is defined by a bias frequency. The bias frequency is, for example, 50 kHz or higher and 27 MHz or lower. The time length of the waveform cycle CY is the reciprocal of the bias frequency.

As illustrated in FIG. 4, the electric bias EB may be bias radio frequency power LF with the bias frequency. In other words, the electric bias EB may have a sinusoidal waveform with the bias frequency. In this case, the bias power supply 32 is electrically connected to the bias electrode via a matcher 34. The variable impedance of the matcher 34 is set to reduce reflection from the load of the bias radio frequency power LF.

Alternatively, the electric bias EB may include a voltage pulse VP. The voltage pulse VP is applied to the bias electrode within the waveform cycle CY. The voltage pulse VP is periodically applied to the bias electrode at a time interval equal to the time length of the waveform cycle CY. The waveform of the voltage pulse VP may be a rectangular wave, a triangular wave, or any other waveform. The polarity of the voltage of the voltage pulse VP is set to create a potential difference between the substrate W and the plasma, thereby drawing ions from plasma to the substrate W. The voltage pulse VP may be a negative voltage pulse or a negative direct current (DC) voltage pulse. In addition, if the electric bias EB is the voltage pulse VP, the plasma processing apparatus 1 may not include the matcher 34.

In one embodiment, the bias power supply 32 may include the signal generator 32g, a D/A converter 32c, and an amplifier 32a, as illustrated in FIG. 3. The signal generator 32g periodically generates a bias signal with a specified waveform and a specified waveform cycle CY. The signal generator 32g may be configured as a programmable logic device such as a programmable processor or FPGA.

The output of the signal generator 32g is connected to the input of the D/A converter 32c. The D/A converter 32c converts the bias signal from the signal generator 32g into an analog signal. The output of the D/A converter 32c is connected to the input of the amplifier 32a. The amplifier 32a amplifies the analog signal from the D/A converter 32c to generate the electric bias EB. The amplification factor of the amplifier 32a is specified to the bias power supply 32 by the controller 2. In addition, the bias power supply 32 may not include the D/A converter 32c. In this case, the output of the signal generator 32g is connected to the input of the amplifier 32a, and the amplifier 32a amplifies the bias signal from the signal generator 32g to generate the electric bias EB.

The radio frequency power supply 31 sets the source frequency in each of multiple phase periods SP within the waveform cycle CY to a frequency obtained by adding a shift amount for minimizing the degree of reflection of the source radio frequency power HF and a disturbance to a source frequency in the same phase period within the preceding waveform cycle CY. An example of the disturbance is random noise. The random noise may be generated according to a normal distribution with a mean value of zero. The maximum absolute value of the random noise generated according to the normal distribution may be 0.01 MHz or more and 5 MHz or less, and for example, 0.5 MHz. The variance of the normal distribution may also be 0.01 MHz or more and 5 MHz or less, and for example, 0.4 MHz. The random noise may be generated according to a uniform distribution. The maximum absolute value of the random noise generated according to the uniform distribution may also be 0.01 MHz or more and 5 MHz or less, and for example, 0.5 MHz. The mean value and variance of the normal distribution that random noise follows, as well as the maximum absolute value of the uniform distribution that the random noise follows may vary according to the degree of reflection during the plasma processing time or the same preceding period. The setting of the source frequency by the radio frequency power supply 31 may be performed based on first feedback and/or second feedback. Details regarding the first feedback and second feedback will be described later.

The plasma processing apparatus 1 is capable of preventing the reflection of the source radio frequency power HF in response to variations in the impedance of the load within the waveform cycle CY by adjusting the source frequency in each of the multiple phase periods SP within the waveform cycle CY. The source frequency in each of the multiple phase periods SP within the waveform cycle CY is obtained by adding the aforementioned shift amount and random noise to the source frequency in the same phase period within the preceding waveform cycle CY. With the plasma processing apparatus 1, it is possible to avoid remaining at a frequency at which a local minimum value of the degree of reflection is obtained, and to search for a source frequency that reduces the degree of reflection, by such random noise.

### [First Feedback]

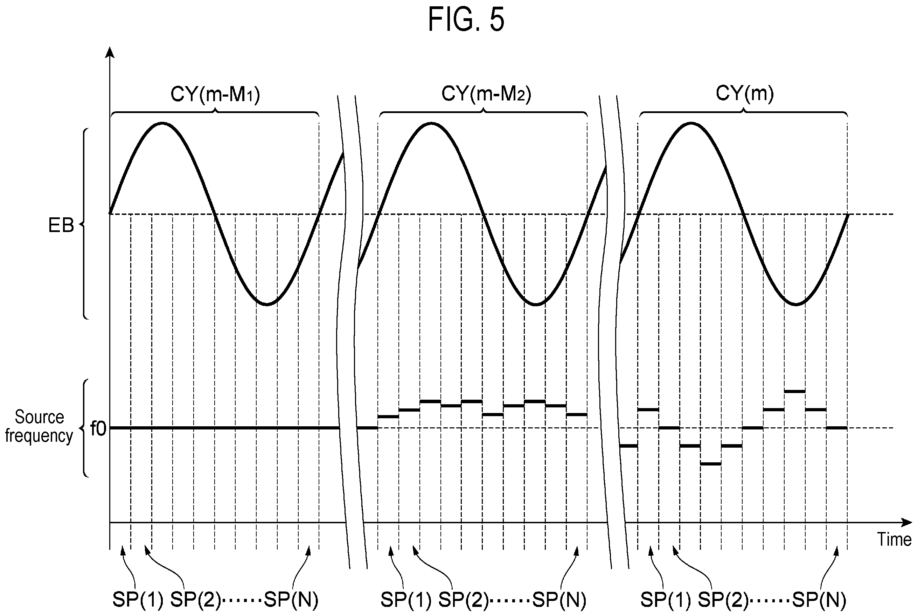

Hereinafter, first feedback will be described with reference to FIG. 5. FIG. 5 is a timing chart illustrating an example of the electric bias and the source frequency of the source radio frequency power. First feedback is performed to adjust the source frequency in each of multiple phase periods SP within each of multiple consecutive waveform cycles CY. Each of the multiple waveform cycles CY includes N phase periods SP(1) to SP(N). N is an integer equal to or greater than 2. The N phase periods SP(1) to SP(N) divide each of the multiple waveform cycles CY into N phase periods. In the following description, the waveform cycle CY(m) indicates the m^{th} waveform cycle among the multiple waveform cycles CY. The phase period SP(n) indicates the n^{th} phase period among the phase periods SP(1) to SP(N). Further, the phase period SP(m, n) indicates the n^{th} phase period within the waveform cycle CY(m).

The setting of the source frequency in the first feedback may be performed by the radio frequency power supply 31 (or the signal generator 31g). The radio frequency power supply 31 sets the source frequency of the source radio frequency power HF in the phase period SP(m, n) according to a change in the degree of reflection of the source radio frequency power HF.

To determine the degree of reflection of the source radio frequency power HF, the plasma processing apparatus 1 may further include a sensor 35 and/or a sensor 36 (see FIG. 2). The sensor 35 is configured to measure a power level Pr of a reflected wave from the load of the source radio frequency power HF. The sensor 35 includes, for example, a directional coupler. The directional coupler may be provided between the radio frequency power supply 31 and the matcher 33. The sensor 35 may be configured to also measure a power level Pf of a forward wave of the source radio frequency power HF. The power level Pr of the reflected wave measured by the sensor 35 is notified to the radio frequency power supply 31. Furthermore, the power level Pf of the forward wave may also be notified from the sensor 35 to the radio frequency power supply 31.

The sensor 36 includes a voltage sensor and a current sensor. The sensor 36 is configured to measure a voltage V_{HF} and current I_{HF} in a feed line interconnecting the radio frequency power supply 31 and the radio frequency electrode. The source radio frequency power HF is supplied to the radio frequency electrode through the feed line. The sensor 36 may be located between the radio frequency power supply 31 and the matcher 33. The voltage V_{HF} and current I_{HF} are notified to the radio frequency power supply 31.

The radio frequency power supply 31 generates a representative value from measurement values taken in each of the multiple phase periods SP. The measurement value may be the power level Pr of the reflected wave acquired by the sensor 35. The measurement value may also be the ratio (i.e., the reflectivity) of the power level Pr of the reflected wave to the output power level of the source radio frequency power HF. The measurement value may also be the phase difference θ between the voltage V_{HF} and current I_{HF} acquired by the sensor 36 in each of the multiple phase periods SP. The measurement value may be the load-side impedance Z_{L} of the radio frequency power supply 31 in each of the multiple phase periods SP. The impedance Z_{L} is determined from the voltage V_{HF} and the current I_{HF} acquired by the sensor 36. The measurement value may be a reflection coefficient determined from the impedance Z_{L} and the output impedance of the radio frequency power supply 31. The representative value may be the mean value or the maximum value of the measurement values taken in each of the multiple phase periods SP. The radio frequency power supply 31 uses the representative value in each of the multiple phase periods SP as a value that indicates the degree of reflection of the source radio frequency power HF.

In the first feedback, the radio frequency power supply 31 identifies a change in the degree of reflection by using different source frequencies in the corresponding phase period SP(n) within each of two or more waveform cycles CY preceding the waveform cycle CY(m).

In one embodiment, the two or more waveform cycles CY preceding the waveform cycle CY(m) include a waveform cycle CY(m-M₁) and a waveform cycle CY(m-M₂), as illustrated in FIG. 5. Here, M₁ and M₂ are natural numbers that satisfy M₁>M₂. In one embodiment, the waveform cycle CY(m-M₁) is represented as a waveform cycle CY(m-2Q), and the waveform cycle CY(m-M₂) as a waveform cycle CY(m-Q). "Q" and "M₂" may be "1", while "2Q" and "M₁" may be "2". "Q" may also be an integer greater than or equal to 2. In the example of FIG. 5, the source frequency in each of the multiple phase periods SP within the waveform cycle CY(m-M₁) is the same f0, but may also be different.

In the first feedback, the radio frequency power supply 31 determines the source frequency f_{HF}(m-M2, n) by f_{HF}(m-M₂, n)=f_{HF}(m-M₁, n)+Δ(m-M₂, n)+R(m-M₂, n). Then, the source frequency f_{HF}(m, n) is determined by f_{HF}(m, n)=f_{HF}(m-M₂, n)+Δ(m, n)+R(m, n). Here, f_{HF} (m, n) indicates the source frequency of the source radio frequency power HF in the phase period SP(m, n). Δ(m, n) is the frequency shift amount used to determine the source frequency f_{HF}(m, n). R(m, n) is the random noise used to determine the source frequency f_{HF}(m, n). Δ(m, n) is an amount that causes an increase or decrease in frequency. If Δ(m, n) is positive, it provides a frequency shift in the positive direction. If Δ(m, n) is negative, it provides a frequency shift in the negative direction.

In the first feedback, the degree of reflection in the phase period SP(m-M₂, n) may decrease compared to the degree of reflection in the phase period SP(m-M₁, n). In this case, the radio frequency power supply 31 sets Δ(m, n), which is used to determine the source frequency f_{HF}(m, n), to an amount having the same shift direction as the shift direction of f_{HF}(m-M₂, n) with respect to f_{HF}(m-M₁, n).

In the first feedback, the degree of reflection in the phase period SP(m-M₂, n) may increase compared to the degree of reflection in the phase period SP(m-M₁, n). In this case, the radio frequency power supply 31 sets Δ(m, n), which is used to determine the source frequency f_{HF}(m, n), to an amount having a shift direction opposite to the shift direction of f_{HF}(m-M₂, n) with respect to f_{HF}(m-M₁, n).

In one embodiment, the shift amount Δ(m, n) may have a fixed absolute value. In other words, the shift amount used to determine the source frequency in each of the multiple phase periods SP may have the same fixed absolute value. In another embodiment, the shift amount Δ(m, n) may have an absolute value depending on the magnitude of the degree of reflection in the phase period SP(m-M₂, n).

### [Second Feedback]

Second feedback is used when the bias power supply 32 periodically supplies a pulse EBP of the electric bias EB to the bias electrode. The pulse EBP is supplied to the bias electrode in each of multiple pulse periods PP. Each of the multiple pulse periods PP includes a repetition of the waveform period CY. In other words, the electric bias EB is periodically supplied to the bias electrode in each of the multiple pulse periods PP.

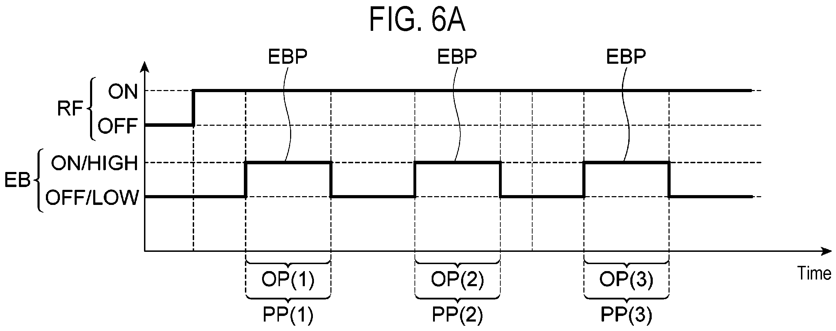

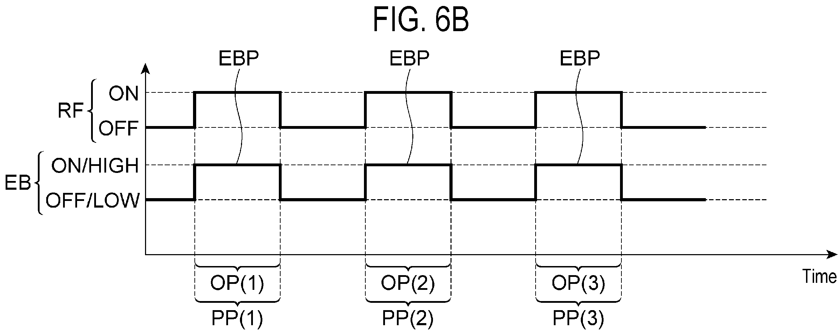

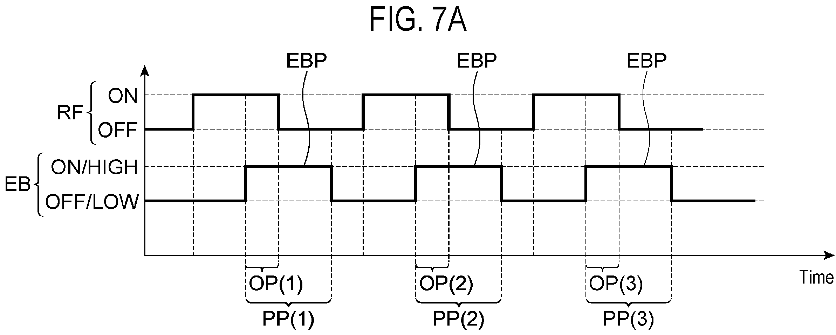

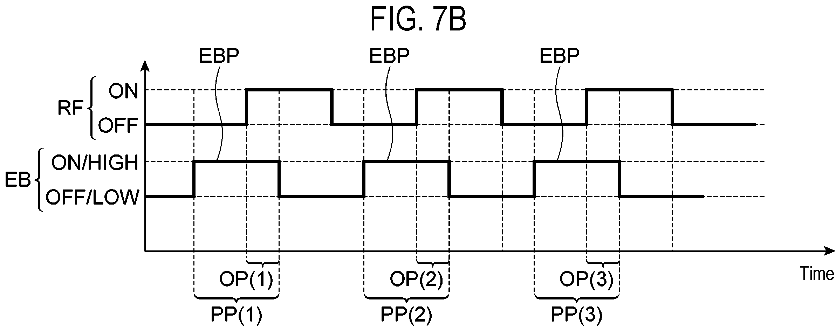

Here, reference will be made to FIGS. 6A, 6B, 7A and 7B. Each of FIGS. 6A, 6B, 7A and 7B is a timing chart of an example of the source radio frequency power HF and electric bias EB. In these drawings, "ON" for the source radio frequency power HF indicates that the source radio frequency power HF is being supplied, and "OFF" for the source radio frequency power HF indicates that the supply of the source radio frequency power HF is stopped. Further, in these drawings, "ON" for the electric bias EB indicates that the electric bias EB is being applied to the bias electrode, and "OFF" for the electric bias EB indicates that no electric bias EB is applied to the bias electrode. Further, in these figures, "HIGH" for the electric bias EB indicates that the electric bias EB having a higher level than that of the electric bias EB indicated by "LOW" is applied to the bias electrode.

The multiple pulse periods PP appear sequentially over time. The multiple pulse periods PP appear sequentially at intervals (cycles) corresponding to the reciprocal of the pulse frequency. In the following description, the pulse period PP(k) indicates the k^{th} pulse period among the multiple pulse periods PP. The pulse frequency is lower than the bias frequency and is, for example, 1 kHz or more and 100 kHz or less. As described above, the electric bias EB is applied periodically to the bias electrode in each of the multiple pulse periods PP. The electric bias EB may not be applied to the bias electrode in a period other than the multiple pulse periods PP. Alternatively, the electric bias EB with a lower level than that of the electric bias EB in the multiple pulse periods PP may be applied to the bias electrode in a period other than the multiple pulse periods PP.

As illustrated in FIG. 6A, the source radio frequency power HF may be supplied as a continuous wave. In the example illustrated in FIG. 6A, multiple overlap periods OP, where the source radio frequency power HF is supplied in the multiple pulse periods PP, coincide with the multiple pulse periods PP, respectively.

Alternatively, as illustrated in FIGS. 6B, 7A and 7B, the pulse of the source radio frequency power HF may be supplied. As illustrated in FIG. 6B, the pulse of the source radio frequency power HF may be supplied in each of multiple periods, which coincides with the multiple pulse periods PP. In the example illustrated in FIG. 6B, multiple overlap periods OP, where the source radio frequency power HF is supplied in the multiple pulse periods PP, coincide with the multiple pulse periods PP, respectively. As illustrated in FIGS. 7A and 7B, the pulse of the source radio frequency power HF may be supplied in multiple periods, each of which partially overlaps the multiple pulse periods PP. In the examples illustrated in FIGS. 7A and 7B, each of the multiple overlap periods OP, where the source radio frequency power HF is supplied in the multiple pulse periods PP, is a part of the corresponding pulse period PP among the multiple pulse periods PP. In addition, in the following description, the overlap period OP(k) indicates the k^{th} overlap period among the multiple overlap periods OP.

The electric bias EB is applied to the bias electrode in each of multiple waveform cycles CY within each of the multiple pulse periods PP. In the following description, the waveform cycle CY(m) indicates the m^{th} waveform cycle among multiple waveform cycles CY(1) to CY(M) within each of the multiple overlap periods OP. Further, the waveform cycle CY(k, m) indicates the m^{th} waveform cycle within the k^{th} overlap period. Further, the phase period SP(n) indicates the n^{th} phase period among the multiple phase periods SP(1) to SP(N) in each of the multiple waveform cycles CY within each of the multiple overlap periods OP. Further, the phase period SP(m, n) indicates the n^{th} phase period in the waveform cycle CY(m). Further, the phase period SP(k, m, n) indicates the n^{th} phase period in the waveform cycle CY(m) within the k^{th} overlap period OP(k).

The setting of the source frequency in each of the multiple phase periods SP within each of the multiple waveform cycles CY for each of overlap periods OP(1) to OP(T-1) may be based on the above-described first feedback. In addition, T is an integer greater than or equal to 3. Alternatively, the source frequency in each of the multiple phase periods SP within each of the multiple waveform cycles CY for each of the overlap periods OP(1) to OP(T-1) may be set to a frequency registered in a pre-prepared table.

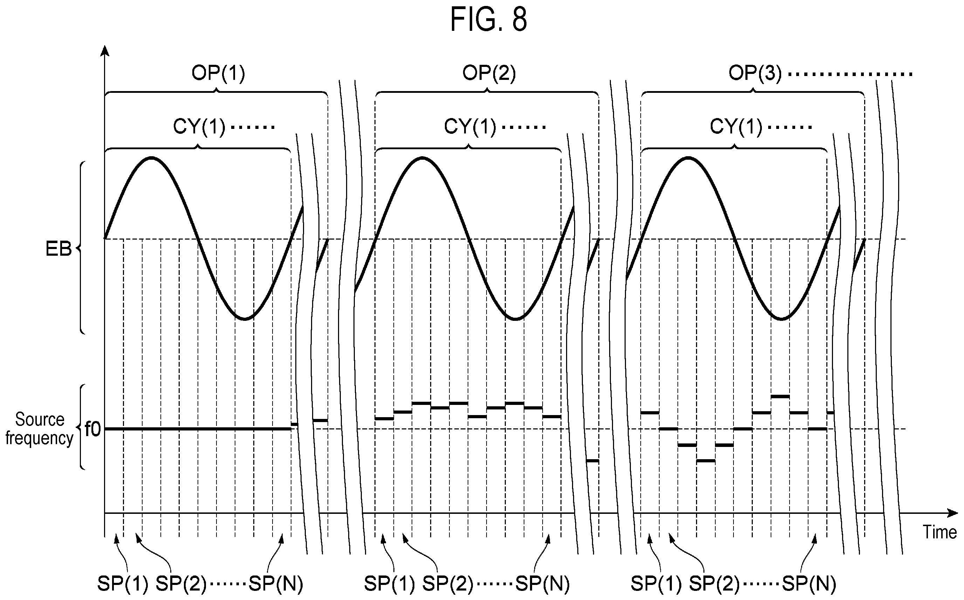

Second feedback may be used in the setting of the source frequency of the source radio frequency power HF for the overlap period following the overlap period OP(T). Hereinafter, the second feedback will be described with reference to FIG. 8. FIG. 8 is a timing chart illustrating an example of the electric bias and the source frequency of source radio frequency power.

In the second feedback, the radio frequency power supply 31 adjusts the source frequency f_{HF}(k, m, n) according to a change in the degree of reflection of the source radio frequency power HF as described above. In the second feedback, a change in the degree of reflection is identified by using different source frequencies of the source radio frequency power HF in the corresponding phase period SP(n) within the waveform cycle CY(m) for two or more overlap periods OP preceding the overlap period OP(k).

In one embodiment, two or more overlap periods OP preceding the overlap period OP(k) include a (k-K₁)^{th} overlap period OP(k-K₁) and a (k-K₂)^{th} overlap period OP(k-K₂). Here, K₁ and K₂ are natural numbers that satisfy K₁>K₂. In one embodiment, the overlap period OP(k-K₁) is the overlap period OP(k-2). The overlap period OP(k-K₂) is the overlap period following the overlap period OP(k-K₁), which is the overlap period OP(k-1) in one embodiment. That is, in one embodiment, K₂ and K₁ are 1 and 2, respectively.

In the second feedback, the radio frequency power supply 31 determines the source frequency f_{HF}(k-K₂, m, n) by f_{HF}(k-K₂, m, n)=f_{HF}(k-K₁, m, n)+Δ(k-K₂, m, n)+R(k-K₂, m, n). Then, the source frequency f_{HF}(k, m, n) is obtained by f_{HF}(k, m, n)=f_{HF}(k-K₂, m, n)+Δ(k, m, n)+R(k, m, n). Here, f_{HF} (k, m, n) indicates the source frequency of the source radio frequency power HF in the phase period SP(k, m, n). Δ(k, m, n) is the frequency shift amount used to determine the source frequency f_{HF}(k, m, n) in the phase period SP(k, m, n). R(k, m, n) indicates the random noise used to determine the source frequency f_{HF}(k, m, n) in the phase period SP(k, m, n). Δ(k, m, n) is an amount that causes an increase or decrease in frequency. If Δ(k, m, n) is positive, it provides a frequency shift in the positive direction. If Δ(k, m, n) is negative, it provides a frequency shift in the negative direction.

In the second feedback, the degree of reflection in the phase period SP(k-K₂, m, n) may decrease compared to the degree of reflection in the phase period SP(k-K₁, m, n). In this case, the radio frequency power supply 31 sets Δ(k, m, n), which is used to determine the source frequency f_{HF}(k, m, n), to an amount having the same shift direction as the shift direction of f_{HF}(k-K₂, m, n) with respect to f_{HF}(k-K₁, m, n).

In the second feedback, the degree of reflection in the phase period SP(k-K₂, m, n) may increase compared to the degree of reflection in the phase period SP(k-K₁, m, n). In this case, the radio frequency power supply 31 sets Δ(k, m, n), which is used to determine the source frequency f_{HF}(k, m, n), to an amount having a shift direction opposite to the shift direction of f_{HF}(k-K₂, m, n) with respect to f_{HF}(k-K₁, m, n).

In one embodiment, the shift amount Δ(k, m, n) may have a fixed absolute value. In other words, the shift amount used to determine the source frequency in each of the multiple phase periods SP may have the same fixed absolute value. In another embodiment, the shift amount Δ(k, m, n) may have an absolute value depending on the magnitude of the degree of reflection in the phase period SP(k-K₂, m, n).

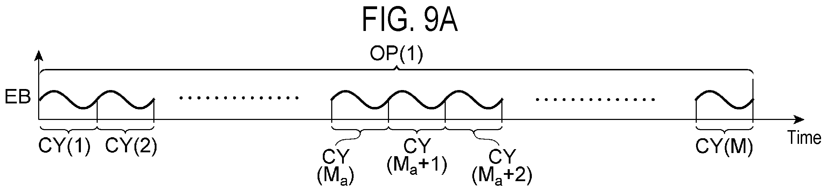

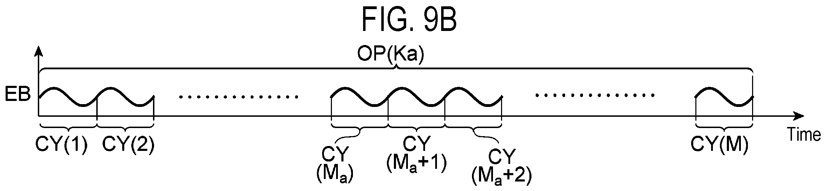

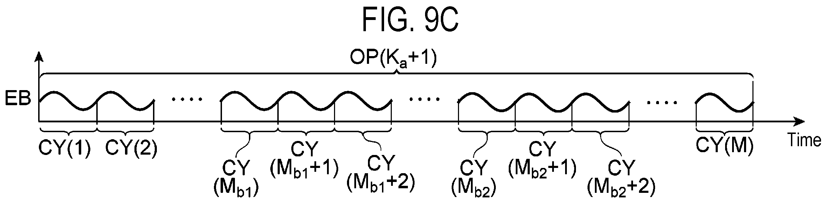

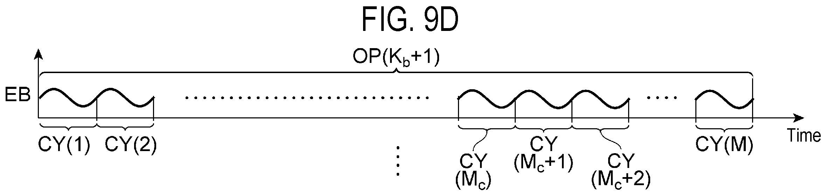

Hereinafter, reference will be made to FIGS. 9A to 9D. FIGS. 9A and 9D are timing charts illustrating another example of an electric bias, respectively. In one embodiment, the multiple overlap periods OP may include first to Kₐ^{th} overlap periods OP(1) to OP(Kₐ). Here, Kₐ is a natural number greater than or equal to 2.

The radio frequency power supply 31 may perform an initial processing in each of first to Mₐ^{th} waveform cycles CY(1) to CY(Mₐ), among the multiple waveform cycles Cy included in each of the overlap periods OP(1) to OP(Kₐ). Here, Mₐ is a natural number. In the initial processing, a frequency set group including multiple frequency sets for each of the waveform cycles CY(1) to CY(Mₐ) may be used, and the multiple frequency sets included in that frequency set group may differ from each other. Further, multiple frequency set groups for each of the overlap periods OP(1) to OP(Kₐ) may be used, and these multiple frequency set groups may differ from each other. The radio frequency power supply 31 uses, as the source frequency, multiple frequencies included in a corresponding frequency set in the multiple phase periods SP within each of the first to Mₐ^{th} waveform cycles CY(1) to CY(Mₐ) for each of the overlap periods OP(1) to OP(Kₐ). In addition, the multiple frequency sets and multiple frequency set groups may be stored in a storage of either the controller 2 or the radio frequency power supply 31.

The radio frequency power supply 31 may perform the above-described first feedback after the waveform cycle CY(Mₐ) in each of the overlap periods OP(1) to OP(Kₐ). In other words, the radio frequency power supply 31 may perform the above-described first feedback in waveform cycles CY(Ma+1) to CY(M) included in each of the overlap period OP(1) to OP(Kₐ).

In one embodiment, the multiple overlap periods OP may further include (Kₐ+1)^{th} to K_{b}^{th} overlap periods OP(Kₐ+1) to OP(K_{b}). Here, K_{b} is a natural number equal to or greater than (Kₐ+1) and may satisfy K_{b}=Kₐ+1.

The radio frequency power supply 31 may perform the above-described initial processing in each of first to M_{b1}^{th} waveform cycles CY(1) to CY(M_{b1}) included in each of the overlap periods OP(Kₐ+1) to OP(Kₐ). Here, M_{b1} is a natural number. M_{b1} and Mₐ may satisfy M_{b1}<Mₐ.

The radio frequency power supply 31 may perform the above-described second feedback in a (M_{b1}+1)^{th} waveform cycle CY(M_{b1}+1) to a M_{b2}^{th} waveform cycle CY(M_{b2}) among the multiple waveform cycles CY included in each of the overlap periods OP(Kₐ+1) to OP(K_{b}). Here, M_{b2} is a natural number that satisfies M_{b2}>M_{b1}.

The radio frequency power supply 31 may perform the above-described first feedback after the waveform cycle CY(M_{b2}) in each of the overlap periods OP(Kₐ+1) to OP(K_{b}). In other words, the radio frequency power supply 31 may perform the above-described first feedback in waveform cycles CY(Mₚ₂+1) to CY(M) included in each of the overlap periods OP(Kₐ+1) to OP(K_{b}).

Further, the radio frequency power supply 31 may perform the above-described second feedback in first to M_{c}^{th} waveform cycles CY(1) to CY(M_{c}) included in each of a (Kb+1)^{th} overlap period OP(K_{b}+1) to the last overlap period OP(K). Here, M_{c} is a natural number. Further, the radio frequency power supply 31 may perform the above-described first feedback after the waveform cycle CY(M_{c}) in each of the overlap periods OP(K_{b}+1) to OP(K). In other words, the radio frequency power supply 31 may perform the above-described first feedback in the waveform cycles CY(M_{c}+1) to CY(M) included in each of the overlap periods OP(K_{b}+1) to OP(K).

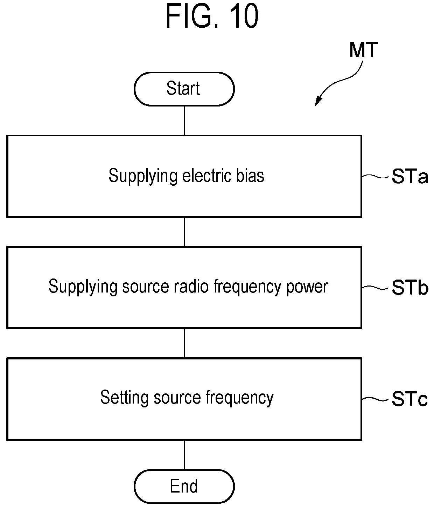

Hereinafter, a method of controlling the source frequency of source radio frequency power according to one exemplary embodiment will be described with reference to FIG. 10. FIG. 10 is a flowchart illustrating a method of controlling the source frequency of source radio frequency power according to one exemplary embodiment. The method MT illustrated in FIG. 10 starts with either step STa or step STb.

In step STa, the electric bias EB is supplied to the bias electrode. The electric bias EB is supplied continuously or as a periodic pulse EBP as described above. Step STb is performed in parallel with step STa. In step STb, the source radio frequency power HF is supplied to the radio frequency electrode to generate plasma within the chamber. The source radio frequency power HF is supplied continuously or as a periodic pulse as described above.

In step STc, the source frequency of the source radio frequency power HF used in each of the multiple phase periods SP of the multiple waveform cycles CY is set. In step STc, the source frequency in each of the multiple phase periods SP within the waveform cycle CY is set to a frequency obtained by adding a shift amount for minimizing the degree of reflection of the source radio frequency power and a disturbance (e.g., random noise) to the source frequency in the same phase period within the preceding waveform cycle CY. For a specific example of setting the source frequency, reference can be made to the description of the setting of the source frequency performed by the radio frequency power supply 31 described above.

While various exemplary embodiments have been described above, various additions, omissions, substitutions, and modifications may be made without being limited to the exemplary embodiments described above. Further, elements from different embodiments may be combined to form other embodiments.

In another embodiment, the plasma processing apparatus may be of a different type such as an inductively coupled plasma processing apparatus, an ECR plasma processing apparatus, a helicon wave excited plasma processing apparatus, or a surface wave plasma processing apparatus. In any of these plasma processing apparatuses, the source radio frequency power HF is used for plasma generation, and the source frequency of the source radio frequency power HF used in the multiple phase periods SP of the multiple waveform cycles CY is set as described above for the plasma processing apparatus 1.

In still another embodiment, other disturbances may be used instead of the random noise described above. The other disturbances may be randomly applied fixed values.
Alternatively, the other disturbances may be variable values.

Here, various exemplary embodiments included in the present disclosure are described in the following [E1] to [E12].

### [E1]

A plasma processing apparatus comprising:
a chamber;
a substrate support having a bias electrode and provided inside the chamber;
a radio frequency power supply configured to generate source radio frequency power for plasma generation within the chamber; and
a bias power supply configured to periodically supply an electric bias having a waveform cycle to the bias electrode,
wherein the radio frequency power supply is configured to set a source frequency of the source radio frequency power in each of a plurality of phase periods within the waveform cycle to a frequency obtained by adding a shift amount for minimizing a degree of reflection of the source radio frequency power and random noise to the source frequency in a same phase period within a preceding waveform cycle.

### [E2]

The plasma processing apparatus as described in [E1], wherein the radio frequency power supply is configured to:
if the degree of reflection in a n^{th} phase period within a (m-M₂)^{th} waveform cycle among a plurality of waveform cycles that are repetitions of the waveform cycle decreases compared to the degree of reflection in the n^{th} phase period within a (m-M₁)^{th} waveform cycle among the plurality of waveform cycles, set the shift amount, which is applied to the source frequency in the n^{th} phase period within the (m-M₂)^{th} waveform cycle in order to set the source frequency in the n^{th} phase period within a m^{th} waveform cycle among the plurality of waveform cycles, to an amount having the same shift direction as that of the source frequency in the n^{th} phase period within the (m-M₂)^{th} waveform cycle with respect to the source frequency in the n^{th} phase period within the (m-M₁)^{th} waveform cycle; and
if the degree of reflection in the n^{th} phase period within the (m-M₂)^{th} waveform cycle among the plurality of waveform cycles increases compared to the degree of reflection in the n^{th} phase period within the (m-M₁)^{th} waveform cycle, set the shift amount, which is applied to the source frequency in the n^{th} phase period within the (m-M₂)^{th} waveform cycle in order to set the source frequency in the n^{th} phase period within the m^{th} waveform cycle, to an amount having a shift direction opposite to that of the source frequency in the n^{th} phase period within the (m-M₂)^{th} waveform cycle with respect to the source frequency in the n^{th} phase period within the (m-M₁)^{th} waveform cycle (here, M₁ and M₂ are natural numbers that satisfy M₁>M₂).

### [E3]

The plasma processing apparatus as described in [E2], wherein the shift amount has a fixed absolute value.

### [E4]

The plasma processing apparatus as described in [E2], wherein the shift amount, which is applied to the source frequency in the n^{th} phase period within the (m-M₂)^{th} waveform cycle in order to set the source frequency in the n^{th} phase period within the m^{th} waveform cycle, has an absolute value depending on a magnitude of the degree of reflection in the n^{th} phase period within the (m-M₂)^{th} waveform cycle.

### [E5]

The plasma processing apparatus as described in **[E1],** wherein the bias power supply is configured to periodically supply the electric bias so as to cause a plurality of waveform cycles that are repetitions of the waveform cycle for each of a plurality of pulse periods, and
wherein the radio frequency power supply is configured to:
if the degree of reflection in a n^{th} phase period within a m^{th} waveform cycle within a (k-K₂)^{th} overlap period among a plurality of overlap periods overlapping the plurality of pulse periods decreases compared to the degree of reflection in the n^{th} phase period within the m^{th} waveform cycle within a (k-K₁)^{th} overlap period among the plurality of overlap periods, set the shift amount, which is applied to the source frequency in the n^{th} phase period within the m^{th} waveform cycle within the (k-K₂)^{th} overlap period in order to set the source frequency in the n^{th} phase period within the m^{th} waveform cycle within a k^{th} overlap period among the plurality of overlap periods, to an amount having the same shift direction as that of the source frequency in the n^{th} phase period within the m^{th} waveform cycle within the (k-K₂)^{th} overlap period with respect to the source frequency in the n^{th} phase period within the m^{th} waveform cycle within the (k-K₁)^{th} overlap period; and
if the degree of reflection in the n^{th} phase period within the m^{th} waveform cycle within the (k-K₂)^{th} overlap period increases compared to the degree of reflection in the n^{th} phase period within the m^{th} waveform cycle within the (k-K₁)^{th} overlap period, set the shift amount, which is applied to the source frequency in the n^{th} phase period within the m^{th} waveform cycle within the (k-K₂)^{th} overlap period in order to set the source frequency in the n^{th} phase period within the m^{th} waveform cycle within the k^{th} overlap period, to an amount having a shift direction opposite to that of the source frequency in the n^{th} phase period within the m^{th} waveform cycle within the (k-K₂)^{th} overlap period with respect to the source frequency in the n^{th} phase period within the m^{th} waveform cycle within the (k-K₁)^{th} overlap period (here, K₁ and K₂ are natural numbers that satisfy K₁>K₂).

### [E6]

The plasma processing apparatus as described in [E5], wherein the shift amount has a fixed absolute value.

### [E7]

The plasma processing apparatus as described in [E5], wherein the shift amount, which is applied to the source frequency in the n^{th} phase period within the m^{th} waveform cycle within the (k-K₂)^{th} overlap period in order to set the source frequency in the n^{th} phase period within the m^{th} waveform cycle within the k^{th} overlap period, has an absolute value depending on a magnitude of the degree of reflection in the n^{th} phase period within the m^{th} waveform cycle within the (k-K₂)^{th} overlap period.

### [E8]

The plasma processing apparatus as described in any one of [E1] to [E7], wherein the random noise is generated according to a normal distribution with a mean value of zero.

### [E9]

The plasma processing apparatus as described in any one of [E1] to [E7], wherein the random noise is generated according to a uniform distribution.

### [E10]

The plasma processing apparatus as described in any one of [E1] to [E9], wherein the electric bias is either bias radio frequency power with a bias frequency that is a reciprocal of a time length of the waveform cycle, or a voltage pulse generated periodically at a time interval of the waveform cycle.

### [E11]

A plasma processing apparatus comprising:
a chamber;
a substrate support having a bias electrode and provided inside the chamber;
a radio frequency power supply configured to generate source radio frequency power for plasma generation within the chamber; and
a bias power supply configured to periodically supply an electric bias having a waveform cycle to the bias electrode,
wherein the radio frequency power supply is configured to set a source frequency of the source radio frequency power in each of a plurality of phase periods within the waveform cycle to a frequency obtained by adding a shift amount for minimizing a degree of reflection of the source radio frequency power and a disturbance to the source frequency in a same phase period within a preceding waveform cycle.

### [E12]

A method of controlling a source frequency of source radio frequency power, comprising:
applying an electric bias to a bias electrode of a substrate support provided inside a chamber of a plasma processing apparatus, the electric bias having a waveform cycle and being applied periodically to the bias electrode;
supplying the source radio frequency power from a radio frequency power supply for plasma generation within the chamber; and
setting the source frequency of the source radio frequency power in each of a plurality of phase periods within the waveform cycle,
wherein in the setting the source frequency, the source frequency of the source radio frequency power in each of the plurality of phase periods within the waveform cycle is set to a frequency obtained by adding a shift amount for minimizing a degree of reflection of the source radio frequency power and random noise to the source frequency of the source radio frequency power in a same phase period within a preceding waveform cycle.

It will be understood from the above description that various embodiments of the present disclosure have been set forth herein for purpose of illustration, and that various changes may be made without departing from the scope of the present disclosure. Accordingly, the various embodiments disclosed herein are not intended to be limiting, and the true scope is indicated by the appended claims.

### EXPLANATION OF REFERENCE NUMERALS

1: plasma processing apparatus, 10: chamber, 31: radio frequency power supply, 32: bias power supply

## Claims

1. A plasma processing apparatus comprising:
a chamber;
a substrate support having a bias electrode and provided inside the chamber;
a radio frequency power supply configured to generate source radio frequency power for plasma generation within the chamber; and
a bias power supply configured to periodically supply an electric bias having a waveform cycle to the bias electrode,
wherein the radio frequency power supply is configured to set a source frequency of the source radio frequency power in each of a plurality of phase periods within the waveform cycle to a frequency obtained by adding a shift amount for minimizing a degree of reflection of the source radio frequency power and random noise to the source frequency in a same phase period within a preceding waveform cycle.

2. The plasma processing apparatus of Claim 1, wherein the radio frequency power supply is configured to:
if the degree of reflection in a n^{th} phase period within a (m-M₂)^{th} waveform cycle among a plurality of waveform cycles that are repetitions of the waveform cycle decreases compared to the degree of reflection in the n^{th} phase period within a (m-M₁)^{th} waveform cycle among the plurality of waveform cycles, set the shift amount, which is applied to the source frequency in the n^{th} phase period within the (m-M₂)^{th} waveform cycle in order to set the source frequency in the n^{th} phase period within a m^{th} waveform cycle among the plurality of waveform cycles, to an amount having the same shift direction as that of the source frequency in the n^{th} phase period within the (m-M₂)^{th} waveform cycle with respect to the source frequency in the n^{th} phase period within the (m-M₁)^{th} waveform cycle; and
if the degree of reflection in the n^{th} phase period within the (m-M₂)^{th} waveform cycle among the plurality of waveform cycles increases compared to the degree of reflection in the n^{th} phase period within the (m-M₁)^{th} waveform cycle, set the shift amount, which is applied to the source frequency in the n^{th} phase period within the (m-M₂)^{th} waveform cycle in order to set the source frequency in the n^{th} phase period within the m^{th} waveform cycle, to an amount having a shift direction opposite to that of the source frequency in the n^{th} phase period within the (m-M₂)^{th} waveform cycle with respect to the source frequency in the n^{th} phase period within the (m-M₁)^{th} waveform cycle,
wherein M₁ and M₂ are natural numbers that satisfy M₁>M₂.

3. The plasma processing apparatus of Claim 2, wherein the shift amount has a fixed absolute value.

4. The plasma processing apparatus of Claim 2, wherein the shift amount, which is applied to the source frequency in the n^{th} phase period within the (m-M₂)^{th} waveform cycle in order to set the source frequency in the n^{th} phase period within the m^{th} waveform cycle, has an absolute value depending on a magnitude of the degree of reflection in the n^{th} phase period within the (m-M₂)^{th} waveform cycle.

5. The plasma processing apparatus of Claim 1, wherein the bias power supply is configured to periodically supply the electric bias so as to cause a plurality of waveform cycles that are repetitions of the waveform cycle for each of a plurality of pulse periods, and
wherein the radio frequency power supply is configured to:
if the degree of reflection in a n^{th} phase period within a m^{th} waveform cycle within a (k-K₂)^{th} overlap period among a plurality of overlap periods overlapping the plurality of pulse periods decreases compared to the degree of reflection in the n^{th} phase period within the m^{th} waveform cycle within a (k-K₁)^{th} overlap period among the plurality of overlap periods, set the shift amount, which is applied to the source frequency in the n^{th} phase period within the m^{th} waveform cycle within the (k-K₂)^{th} overlap period in order to set the source frequency in the n^{th} phase period within the m^{th} waveform cycle within a k^{th} overlap period among the plurality of overlap periods, to an amount having the same shift direction as that of the source frequency in the n^{th} phase period within the m^{th} waveform cycle within the (k-K₂)^{th} overlap period with respect to the source frequency in the n^{th} phase period within the m^{th} waveform cycle within the (k-K₁)^{th} overlap period; and
if the degree of reflection in the n^{th} phase period within the m^{th} waveform cycle within the (k-K₂)^{th} overlap period increases compared to the degree of reflection in the n^{th} phase period within the m^{th} waveform cycle within the (k-K₁)^{th} overlap period, set the shift amount, which is applied to the source frequency in the n^{th} phase period within the m^{th} waveform cycle within the (k-K₂)^{th} overlap period in order to set the source frequency in the n^{th} phase period within the m^{th} waveform cycle within the k^{th} overlap period, to an amount having a shift direction opposite to that of the source frequency in the n^{th} phase period within the m^{th} waveform cycle within the (k-K₂)^{th} overlap period with respect to the source frequency in the n^{th} phase period within the m^{th} waveform cycle within the (k-K₁)^{th} overlap period,
wherein, K₁ and K₂ are natural numbers that satisfy K₁>K₂.

6. The plasma processing apparatus of Claim 5, wherein the shift amount has a fixed absolute value.

7. The plasma processing apparatus of Claim 5, wherein the shift amount, which is applied to the source frequency in the n^{th} phase period within the m^{th} waveform cycle within the (k-K₂)^{th} overlap period in order to set the source frequency in the n^{th} phase period within the m^{th} waveform cycle within the k^{th} overlap period, has an absolute value depending on a magnitude of the degree of reflection in the n^{th} phase period within the m^{th} waveform cycle within the (k-K₂)^{th} overlap period.

8. The plasma processing apparatus of any one of Claims 1 to 7, wherein the random noise is generated according to a normal distribution with a mean value of zero.

9. The plasma processing apparatus of any one of Claims 1 to 7, wherein the random noise is generated according to a uniform distribution.

10. The plasma processing apparatus of any one of Claims 1 to 7, wherein the electric bias is either bias radio frequency power with a bias frequency that is a reciprocal of a time length of the waveform cycle, or a voltage pulse generated periodically at a time interval of the waveform cycle.

11. A plasma processing apparatus comprising:
a chamber;
a substrate support having a bias electrode and provided inside the chamber;
a radio frequency power supply configured to generate source radio frequency power for plasma generation within the chamber; and
a bias power supply configured to periodically supply an electric bias having a waveform cycle to the bias electrode,
wherein the radio frequency power supply is configured to set a source frequency of the source radio frequency power in each of a plurality of phase periods within the waveform cycle to a frequency obtained by adding a shift amount for minimizing a degree of reflection of the source radio frequency power and a disturbance to the source frequency in a same phase period within a preceding waveform cycle.

12. A method of controlling a source frequency of source radio frequency power, comprising:
applying an electric bias to a bias electrode of a substrate support provided inside a chamber of a plasma processing apparatus, the electric bias having a waveform cycle and being applied periodically to the bias electrode;
supplying the source radio frequency power from a radio frequency power supply for plasma generation within the chamber; and
setting the source frequency of the source radio frequency power in each of a plurality of phase periods within the waveform cycle,
wherein in the setting the source frequency, the source frequency of the source radio frequency power in each of the plurality of phase periods within the waveform cycle is set to a frequency obtained by adding a shift amount for minimizing a degree of reflection of the source radio frequency power and random noise to the source frequency of the source radio frequency power in a same phase period within a preceding waveform cycle.
